# EUROPÄISCHE PATENTANMELDUNG

(11) **EP 0 727 931 A2**
(43) Veröffentlichungstag der Anmeldung: **21.08.1996**
(21) Anmeldenummer: 96101387.7
(22) Anmeldetag: 01.02.1996
(51) Int. Cl.: H05K 7/20, B60R 16/02

(54) **Elektronisches Steuermodul**

(30) Priorität: 16.02.1995 DE 19505180
(71) Anmelder: TEMIC TELEFUNKEN microelectronic GmbH, 74072 Heilbronn (DE)
(72) Erfinder: Schuch, Bernhard, D-91616 Neusitz (DE)
(74) Vertreter: Maute, Hans-Jürgen, Dipl.-Ing.

(57) **Zusammenfassung**

Beschrieben wird ein elektronisches Steuermodul aus einem Substratkörper, einer Schaltungsanordnung mit auf einer Oberflächenseite des Substratkörpers planar aufgebrachten SMD-Halbleiterbauelementen, einem Trägerkörper aus einem Material mit hoher Wärmeleitfähigkeit, auf dem Substratkörper und Schaltungsanordnung angeordnet sind, einem die Schaltungsanordnung und den Substratkörper umschließenden Gehäusekörper sowie einem durch den Gehäusekörper und/oder den Trägerkörper hindurchgeführten Steckeranschlußteil mit mehreren Steckeranschlüssen. Zwischen der der Schaltungsanordnung gegenüberliegenden Oberflächenseite des Substratkörpers und dem Trägerkörper ist eine dünne, gleichmäßige Klebeschicht aus einem hochflexiblen, thermisch stabilen Kleber mit guter Haftfähigkeit und hoher Wärmeleitfähigkeit angeordnet, die eine mechanische Entkopplung von Trägerkörper und Substratkörper (ein unabhängiges thermisches Ausdehnungsverhalten von Substratkörper und Trägerkörper) bewirkt.

## Beschreibung

In vielen Anwendungsbereichen werden heutzutage Meßwerte bzw. Meßwertsignale verarbeitende elektronische Steuermodule für unterschiedliche Aufgaben und Wirkungsweisen eingesetzt, insbesondere zur Steuerung von Prozeßabläufen - beispielsweise sind im Kraftfahrzeug-Bereich als elektronische Steuermodule mehrere die Meßwertsignale von Sensoren und die Ausgangssignale von Aktuatoren verarbeitende Steuergeräte zur Steuerung verschiedener Aggregatefunktionen des Kraftfahrzeugs (Motor, Getriebe etc.) vorgesehen. Elektronische Steuermodule bestehen üblicherweise aus einer relativ dicken Leiterplatte (Dicke beispielsweise 15 mm), einer auf dieser Leiterplatte angeordneten Schaltungsanordnung mit Halbleiterbauelementen, und einem die Schaltungsanordnung zum Schutz gegen Umwelteinflüsse umschließenden mechanisch stabilen Gehäusekörper, in dem die Schaltungsanordnung befestigt ist und der einen mit der Schaltungsanordnung elektrisch leitend verbundenen Anschlußstecker mit Anschlußkontakten aufweist - die Leistungs-Halbleiterbauelemente der Schaltungsanordnung sind in der Regel zur besseren wärmeabfuhr ihrer Verlustleistung direkt am Gehäusekörper angebracht. Oftmals werden elektronische Steuermodule in Umgebungen mit großen Temperaturschwankungen eingesetzt, was zu thermischen Belastungen führen kann - beispielsweise können die vorzugsweise im Motorraum untergebrachten Steuergeräte eines Kraftfahrzeugs Temperaturen von -40 °C bis + 150 °C ausgesetzt sein.

Aus der DE 41 02 265 ist ein Gehäuse zur Aufnahme von Halbleiterbauelementen für den Einbau in ein Kraftfahrzeug bekannt, bei dem die (SMD-) Halbleiterbauelemente der Schaltungsanordnung in einer Ebene auf eine Oberflächenseite einer Leiterplatte gelötet sind, die zum Abführen der Verlustleistung der (Leistungs-) Halbleiterbauelemente auf einen Aluminium-Kühlkörper laminiert ist; durch dieses Laminat (ausgehärtetes Epoxyharz) wird zwar eine gute Haftung und somit eine feste Verbindung von Leiterplatte und Kühlkörper gewahrleistet, jedoch auch eine starke mechanische Kopplung zwischen Leiterplatte und Kühlkörper hervorgerufen. Dies hat zur Folge, daß bei thermischen Belastungen
- wegen der fehlenden Flexibilität thermo-mechanische Spannungen vom Kühlkörper auf die Leiterplatte und die Lötstellen der SMD-Halbleiterbauelemente übertragen werden; einerseits muß die Leiterplatte diese Spannungen verarbeiten können, andererseits versuchen die Lötstellen diese thermo-mechanischen Spannungen mittels Kriechprozessen auszugleichen, was jedoch nach einer bestimmten Belastungszeit zur Ermüdung und zum Bruch der Lötstellen führt.
- aufgrund unterschiedlicher thermischer Ausdehnungskoeffizienten von Leiterplatte und Kühlkörper (beispielsweise beträgt der thermische Ausdehnungskoeffizient der Leiterplatte 16 - 21 · 10⁻⁶/°C, der thermische Ausdehnungskoeffizient des Aluminium-Kühlkörpers ca. 24 · 10⁻⁶/°C) ein Bimetalleffekt entsteht, der zu einem Durchbiegen der Leiterplatte führen kann; dies ist insbesondere bei elektronischen Steuermodulen mit großem Funktionsumfang (hierzu sind eine Vielzahl von Halbleiterbauelementen erforderlich) und daher großflächiger Leiterplatte problematisch. Bei einer Temperaturänderung treten aufgrund von Durchbiegungsänderungen zusätzliche Belastungen auf, insbesondere an den Lötstellen der SMD-Halbleiterbaulemente.
- der Aluminium-Kühlkörper wegen der Fehlanpassung der thermischen Ausdehnungskoeffizienten von Kühlkörper und Leiterplatte über das Laminat einen Zwang dahingehend auf die Leiterplatte ausübt, daß dessen thermischer Ausdehnungskoeffizient vergrößert wird; da jedoch viele SMD-Halbleiterbauelemente einen relativ geringen thermischen Ausdehnungskoeffizienten aufweisen (insbesondere Chip-Kondensatoren, Chip-Widerstände, Quarze etc., deren thermischer Ausdehnungskoeffizient im Bereich von 5 - 10 · 10⁻⁶/°C liegt), wird hierdurch die Differenz der thermischen Ausdehnungskoeffizienten von Leiterplatte und SMD-Halbleiterbauelemente vergrößert und damit auch die Belastung der Lötstellen bei Temperaturänderung.

Als Konsequenz hieraus ergibt sich, daß die Zuverlässigkeit der Lötstellen-Verbindung zwischen den SMD-Halbleiterbauelementen und der Leiterplatte drastisch reduziert wird (insbesondere bei starken thermischen Belastungen), daß die Langzeitstabilität der Lötstellen und damit der gesamten elektronischen Steuermodule vermindert wird und deren Lebensdauer sinkt, und daß der Anwendungsbereich der elektronischen Steuermodule eingeschränkt ist.

Der Erfindung liegt die Aufgabe zugrunde, ein elektronisches Steuermodul gemäß dem Oberbegriff des Patentanspruchs 1 anzugeben, bei dem die genannten Nachteile vermieden werden und das vorteilhafte Eigenschaften aufweist, insbesondere bezüglich Zuverlässigkeit, Lebensdauer, Langzeitstabilität und Anwendungsbereich.
Diese Aufgabe wird gemäß der Erfindung durch die Merkmale im Kennzeichen des Patentanspruchs 1 gelöst.
Vorteilhafte Weiterbildungen der Erfindung ergeben sich aus den Unteransprüchen.

Beim vorgestellten elektronischen Steuermodul wird zur ganzflächigen Verbindung von dem die Schaltungsanordnung mit den SMD-Halbleiterbauelementen aufnehmenden Substratkörper (beispielsweise eine Leiterplatte) und dem Trägerkörper (beispielsweise ein Kühlkörper) eine hochelastische, dünne Klebeschicht mit einem Kleber auf Acrylatbasis als Klebefolie (Klebefilm) mit einer Schichtdicke von beispielsweise 50 - 150 µm gleichmäßig und flächenschlüssig zwischen Trägerkörper und Substratkörper aufgebracht und diese (beispielsweise durch Druck- oder Temperaturbehandlung) miteinander verbunden. Der Kleber der Klebeschicht weist eine hohe Flexibilität auf, wodurch sich Substratkörper und Trägerkörper unabhängig voneinander thermisch ausdehnen können (dies führt zur "mechanischen Entkopplung" von Substratkörper und Trägerkörper, ein Bimetalleffekt wird vermieden), eine geringe, gleichmäßige Dicke und eine relativ hohe Wärmeleitfähigkeit (dies bedingt eine gute Wärmeableitung der Verlustleistung der Halbleiterbauelemente der Schaltungsanordnung vom Substratkörper hin zum Trägerkörper), gleichmäßige Klebeeigenschaften in einem großen Temperaturbereich (dies hat eine lange Lebensdauer der Verbindung zwischen Substratkörper und Trägerkörper zur Folge), eine hohe thermische Stabilität und Unempfindlichkeit gegenüber aggressiven Medien (dies führt zu einer Reduzierung der Umweltbelastung und daher zu einer Erweiterung des Einsatzbereichs), einer trotz Flexibilität genügend großen Haftkraft in einem breiten Temperaturbereich (dies vergrößert die Schwingungsfestigkeit, die für viele Anwendungsfälle erforderlich ist) und eine gute elektrische Isolationsfähigkeit (hierdurch wird eine hohe Spannungsfestigkeit erreicht, beispielsweise bis 500 V).

Vorteilhafterweise wird beim beschriebenen elektronischen Steuermodul (insbesondere bei großflächigen Steuermodulen mit einer Vielzahl von Halbleiterbauelementen)
- infolge der unabhängig voneinander erfolgenden thermischen Ausdehnung von Substratkörper und Trägerkörper (mechanische Entkopplung zwischen Trägerkörper und Substratkörper) bei thermischen Belastungen bzw. thermo-mechanischen Spannungen ein Bimetalleffekt vermieden.
- eine freie und unabhängige Wahl der Materialien und der Abmessungen von Trägerkörper und Substratkörper ermöglicht; diese können auf der Grundlage der mechanischen Entkopplung demzufolge nach bestimmten Gesichtspunkten bzw. Anforderungen optimiert werden - insbesondere kann der thermische Ausdehnungskoeffizient des Substratkörpers (dieser ist unabhängig vom Trägerkörper variabel vorgebbar) so gewählt werden, daß er den thermischen Ausdehnungskoeffizienten der Halbleiterbauelemente der Schaltungsanordnung angepaßt wird (vorzugsweise dem Mittelwert der thermischen Ausdehnungskoeffizienten der Halbleiterbauelemente der Schaltungsanordnung entspricht), wodurch die Fehlanpassung der thermischen Ausdehnungskoeffizienten minimiert und die Lebensdauer der Lötstellen wesentlich erhöht wird (die Vorgabe des thermischen Ausdehnungskoeffizienten des Substratkörpers kann durch entsprechende Wahl des Materials oder der Zusammensetzung des Substratkörpers erfolgen, insbesondere falls der Substratkörper einen mehrschichtigen Aufbau mit Schichten von unterschiedlicher Zusammensetzung aufweist).
- durch die gute Wärmeableitung vom Substratkörper hin zum Trägerkörper eine ausreichende Ableitung der Verlustleistung der SMD-Halbleiterbauelemente der Schaltungsanordnung gewährleistet.
- aufgrund der langen Lebensdauer und der hohen Schwingungsfestigkeit die Zuverlässigkeit und daher auch die mögliche Betriebsdauer erhöht.
- infolge des wählbaren Temperaturbereichs und der Spannungsfestigkeit ein weiter Einsatzbereich gewährleistet bzw. erst ermöglicht (auch bei hohen Belastungen und unterschiedlichen Temperaturanforderungen).

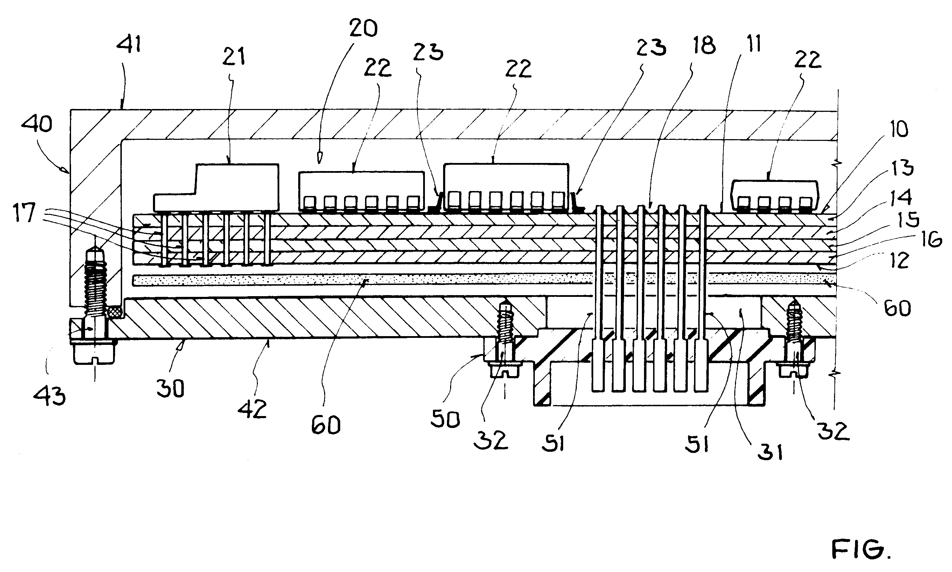

Weiterhin soll als Ausführungsbeispiel ein elektronisches Steuermodul eines Kraftfahrzeugs anhand der Figur näher beschrieben werden; in dieser ist als elektronisches Steuermodul die Schnittzeichnung eines Steuergeräts für den Nutzfahrzeugbereich dargestellt.
Gemäß der Figur besteht das beispielsweise im Motorraum angeordnete großflächige Steuergerät mit planarer Montage der Halbleiterbauelemente und vertikaler Wärmeabfuhr der Verlustleistung der Halbleiterbauelemente aus einer eine hohe Wärmeleitfähigkeit aufweisenden und einen guten Korrosionsschutz bietenden Metall-Trägerplatte als Trägerkörper 30 (beispielsweise aus Aluminium), einer beispielsweise aus 4 Verdrahtungsebenen 13, 14, 15, 16 aus Kupfer mit dazwischenliegenden Laminatschichten ("Prepregs") bestehenden und Durchkontaktierungen 17 sowie Aussparungen 18 aufweisenden Leiterplatte als Substratkörper 10, einer auf der Oberseite 11 der Leiterplatte 10 planar angeordneten Schaltungsanordnung 20 mit einer Vielzahl von passiven und aktiven SMD-Halbleiterbauelementen 21, 22, einem die Schaltungsanordnung 20 zum Schutz der Halbleiterbauelemente 21, 22 umschließenden Gehäusekörper 40 (beispielsweise aus Aluminium), dessen Gehäusedeckel 42 durch die Trägerplatte 30 gebildet wird und mit dessen Gehäuseboden 41 das Steuergerät am Motorblock befestigt wird, und einem Steckeranschlußteil 50 mit beispielsweise 6 Steckeranschlüssen 51, die durch eine Aussparung 31 in der Trägerplatte 30 und die Aussparungen 18 der Leiterplatte 10 hindurchgeführt und mit den SMD-Halbleiterbauelementen 21, 22 der Schaltungsanordnung 20 über Bonddrähte 23 und Verbindungsleitungen (Leiterbahnen) verbunden sind. Zwischen der Trägerplatte 30 und der Unterseite 12 der Leiterplatte 10 ist eine Klebeschicht 60 aus einem modifizierten Acrylatkleber mit einer Dicke von beispielsweise 100 µm gleichmäßig aufgebracht; beispielsweise wird hierzu ein mit einer beidseitigen Schutzschicht versehener Klebefilm zunächst nach einseitigem Abziehen der Schutzschicht auf die Trägerplatte 30 abgerollt und anschließend nach Abziehen der anderen Schutzschicht die Leiterplatte 10 auf dem Klebefilm abgerollt - das Aushärten des Klebers der Klebeschicht 60 erfolgt beispielsweise an Luft. Durch den hochelastischen, gut wärmeleitfähigen, unempfindlichen, thermisch stabilen, sehr haftfähigen, alterungsbeständigen Kleber der Klebeschicht 60 wird eine mechanische Entkopplung von Trägerplatte 30 und Leiterplatte 10 erreicht, die Schwingungsanforderung im Kraftfahrzeug erfüllt (beispielsweise Stabilität bis zu 10g), die Zuverlässigkeit des Steuergeräts erhöht und dessen Lebensdauer verlängert.
Beispielsweise besteht die Aluminium-Trägerplatte 30 mit den Maßen 226 mm x 178 mm x 4 mm aus Aluminium-Druckguß und weist eine Aussparung 31 der Breite 18 mm zur Aufnahme der Steckeranschlüsse 51 des Anschlußsteckerteils 50 auf. Die großflächige Leiterplatte 10 mit den Maßen 217 mm x 147 mm x 0,8 mm besteht aus 4 Verdrahtungsebenen 13, 14, 15, 16 aus Kupfer, die jeweils durch Prepregs (harzgetränkte Glasmatten) getrennt sind; durch die Auswahl der Schichtenfolge der Leiterplatte 10 und der Zusammensetzung der die Verdrahtungsebenen 13, 14, 15, 16 voneinander trennenden Glasmattenschichten, insbesondere von deren Harzanteil, kann der thermische Ausdehnungskoeffizient α_{S} der Leiterplatte 10 in der Ebene variiert werden: beispielsweise wird die Zusammensetzung der Schichten 14, 16 der Leiterplatte 10 so gewählt, daß die Leiterplatte 10 als Vorgabewert α_{V} einen thermischen Ausdehnungskoeffizienten a_{S} von 15 · 10⁻⁶/°C aufweist. Die auf der Oberseite 11 der Leiterplatte 10 einseitig angeordnete Schaltungsanordnung 20 besteht aus ca. 850 SMD-Halbleiterbauelementen mit einem Mittelwert des thermischen Ausdehnungskoeffizienten α_{S} von beispielsweise 15 · 10⁻⁶/°C und umfaßt Chip-Widerstände, Chip-Kondensatoren, Keramik-Kondensatoren, Aluminiumelektrolytkondensatoren, Zenerdioden, Dioden, Quarze, Leistungs-Halbleiterbauelemente 21 und integrierte Schaltungen (ICs) 22; in der Leiterplatte 10 sind unter dem Leistungs-Halbleiterbauelement 21 thermische Durchkontaktierungen 17 zur Verbesserung der Wärmeabfuhr vorgesehen. Der beispielsweise aus Aluminiun bestehende Gehäusekörper 40 besitzt beispielsweise die Maße 23 cm x 18cm x 2 mm und ist mit der Trägerplatte 30 über Schrauben 43 verbunden, ebenso die den Gehäusedeckel 42 bildende Trägerplatte 30 mit dem Steckeranschlußteil 50 über Schrauben 32 (der Steckeranschlußteil 50 kann auch durch den Gehäuseboden 41 hindurchgeführt und mit der Schaltungsanordnung 20 verbunden werden).

## Patentansprüche

1. Elektronisches Steuermodul, bestehend aus
- einem Substratkörper (10),
- einer Schaltungsanordnung (20) mit auf einer Oberflächenseite (11) des Substratkörpers (10) planar aufgebrachten SMD-Halbleiterbauelementen (21, 22),
- einem Trägerkörper (30) aus einem Material mit hoher Wärmeleitfahigkeit, auf dem Substratkörper (10) und Schaltungsanordnung (20) angeordnet sind,
- einem die Schaltungsanordnung (20) und den Substratkörper (10) umschließenden Gehäusekörper (40),
- einem durch den Gehäusekörper (40) und/oder den Trägerkörper (30) hindurchgeführten Steckeranschlußteil (50) mit mehreren Steckeranschlüssen (51),
dadurch gekennzeichnet:
zwischen der der Schaltungsanordnung (20) gegenüberliegenden Oberflachenseite (12) des Substratkörpers (10) und dem Trägerkörper (30) ist eine dünne, gleichmäßige Klebeschicht (60) aus einem hochflexiblen, thermischstabilen Kleber mit guter Haftfähigkeit und hoher Wärmeleitfähigkeit derart angeordnet, daß sich Substratkörper (10) und Trägerkörper (30) bei thermischer Belastung unabhängig voneinander ausdehnen können.

2. Steuermodul nach Anspruch 1, dadurch gekennzeichnet, daß der Substratkörper (10) so ausgebildet ist, daß sein thermischer Ausdehnungskoeffizient (α_{S}) einen einstellbaren Vorgabewert (α_{V}) aufweist.

3. Steuermodul nach einem der Ansprüche 1 oder 2, dadurch gekennzeichnet, daß der Substratkörper (10) aus mehreren übereinander angeordneten Schichten (13, 14, 15, 16) ausgebildet ist.

4. Steuermodul nach Anspruch 3, dadurch gekennzeichnet, daß die Schichten (13, 14, 15, 16) des Substratkörpers (10) so gewählt sind, daß der thermische Ausdehnungskoeffizient (α_{S}) des Substratkörpers (10) den Vorgabewert (α_{V}) aufweist.

5. Steuermodul nach Anspruch 3 oder 4, dadurch gekennzeichnet, daß der Substratkörper (10) als mehrschichtige Leiterplatte mit mehreren Verdrahtungsebenen (13, 14, 15, 16) ausgebildet ist.

6. Steuermodul nach Anspruch 3 oder 4, dadurch gekennzeichnet, daß der Substratkörper (10) als Mehrschicht-Folie ausgebildet ist.

7. Steuermodul nach einem der Ansprüche 2 bis 6, dadurch gekennzeichnet, daß der Vorgabewert (α_{V}) des thermischen Ausdehnungskoeffizienten (α_{S}) des Substratkörpers (10) in Abhängigkeit des thermischen Ausdehnungskoeffizienten (α_{B}) der Halbleiterbauelemente (21, 22) der Schaltungsanordnung (20) gewählt ist.

8. Steuermodul nach Anspruch 7, dadurch gekennzeichnet, daß der Vorgabewert (α_{V}) des thermischen Ausdehnungskoeffizienten (α_{S}) des Substratkörpers (10) dem Mittelwert der thermischen Ausdehnungskoeffizienten (α_{B}) der Halbleiterbauelemente (21, 22) der Schaltungsanordnung (20) entspricht.

9. Steuermodul nach einem der Ansprüche 1 bis 8, dadurch gekennzeichnet, daß die Klebeschicht (60) als Klebefilm zwischen dem Substratkörper (10) und dem Trägerkörper (30) aufgebracht ist.

10. Steuermodul nach einem der Ansprüche 1 bis 9, dadurch gekennzeichnet, daß der Substratkörper (10) Durchkontaktierungen (17) zur Wärmeabfuhr der Verlustleistung der Leistungs-Halbleiterbauelemente (21) der Schaltungsanordnung (20) aufweist.

11. Steuermodul nach einem der Ansprüche 1 bis 10, dadurch gekennzeichnet, daß die Steckeranschlüsse (51) des Steckeranschlußteils (50) senkrecht zur Oberseite (41) des Gehäusekörpers (40) durch den Gehäusekörper (40) hindurchgeführt und mit den Halbleiterbauelementen (21, 22) der Schaltungsanordnung (20) kontaktiert sind.

12. Steuermodul nach einem der Ansprüche 1 bis 10, dadurch gekennzeichnet, daß die Steckeranschlüsse (51) des Steckeranschlußteils (50) senkrecht zur Unterseite (42) des Gehäusekörpers (40) durch den Trägerkörper (30) und den Substratkörper (10) hindurchgeführt und mit den Halbleiterbauelementen (21, 22) der Schaltungsanordnung (20) kontaktiert sind.

13. Steuermodul nach einem der Ansprüche 1 bis 12, dadurch gekennzeichnet, daß die Schaltungsanordnung (20) eine Vielzahl von auf einem großflächigen Substratkörper (10) angeordneten SMD-Halbleiterbauelementen (21, 22) aufweist.

14. Steuermodul nach einem der Ansprüche 1 bis 13, dadurch gekennzeichnet, daß das Steuermodul als Steuergerät eines Kraftfahrzeuges ausgebildet ist.

15. Steuermodul nach Anspruch 14, dadurch gekennzeichnet, daß das Steuergerät im Motorraum des Kraftfahrzeugs angeordnet ist.
